Europäisches Patentamt

European Patent Office

Office européen des brevets

(11) Publication number: 0 558 971 A1

## EUROPEAN PATENT APPLICATION

(21) Application number: 93102134.9

(22) Date of filing: 11.02.93

(51) Int. Cl.5: H03K 3/023

(30) Priority: 13.02.92 JP 26399/92

(43) Date of publication of application:
08.09.93 Bulletin 93/36

(84) Designated Contracting States:
DE FR GB IT

(71) Applicant: TOA MEDICAL ELECTRONICS CO.,
LTD.
2-1, Minatozima-Nakamachi 7-chome
Chuo-ku, Kobe(JP)

(72) Inventor: Kouzuki, Chihiro
86-2 Hanjocho
Kasai-city, Hyogo(JP)

(74) Representative: Tiedtke, Harro, Dipl.-Ing. et al
Patentanwaltsbüro, Tiedtke-Bühling-Kinne &
Partner, Bavariaring 4
D-80336 München (DE)

(54) Hysteresis comparator circuit.

(57) A comparator circuit is provided wherein an input impedance element (Z1) is connected to a non-inverted input terminal (T12) of a comparator (CP), and a feedback impedance element (Z2) is connected between an output terminal (T13) of the comparator (CP) and the non-inverted input terminal (T12). The feedback impedance element (Z2) and input impedance element (Z1) are connected with each other to cooperatively constitute a differentiation circuit when seen from the output terminal side of the comparator (CP). With this arrangement, it becomes possible to eliminate an undesirable extension of the pulse width resulting from a hysteresis and at the same time, to prevent chattering. Further, this hysteresis comparator circuit requires no additional special circuit there by reducing the substrate accommodating space and manufacturing cost.

FIG. 1

[Background of the Invention]

[Field of the Invention]

The present invention relates to a hysteresis comparator circuit which is capable of detecting, for example, the pulse width of an analogue pulse signal supplied from a particle measurement apparatus, without giving rise to an adverse effect such as the generation of noises.

[Description of the Prior Art]

In order to detect the pulse width and the like of an analogue pulse signal, it is general to utilize a hysteresis comparator circuit having a hysteresis characteristic as included in its input-output characteristics.

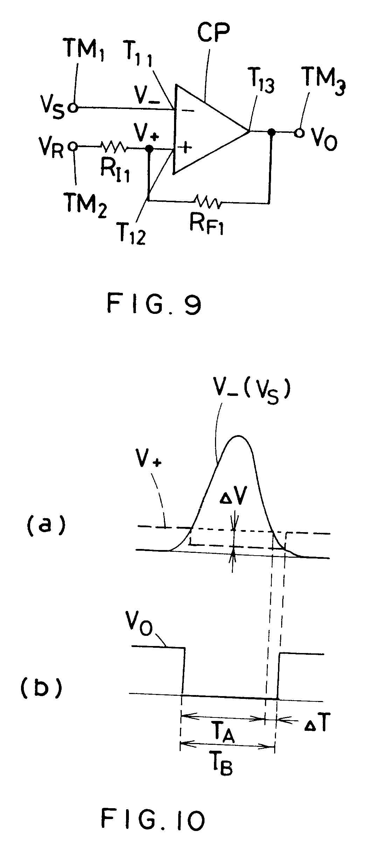

Conventionally, this kind of hysteresis comparator circuit has been constituted such that as shown in Fig. 9, a signal $V_S$ to be detected (or a target signal) is supplied from an input terminal $TM_1$ to an inverted input terminal $T_{11}$ of a comparator CP as a voltage $V_-$.

Further, a reference signal $V_R$ is supplied from an input terminal $TM_2$ via an input resistor $R_{I1}$ to a non-inverted input terminal $T_{12}$ of the comparator CP as a voltage $V_+$.

In addition, an output terminal $T_{13}$ of the comparator CP is connected via a feedback resistance $R_{F1}$ to the non-inverted terminal $T_{12}$.

Then, an output voltage $V_O$ generated from the output terminal $T_{13}$ of the comparator CP is taken out from an output terminal $TM_3$.

Thus, with such a circuit arrangement that the input resistor $R_{I1}$ is connected to the non-inverted input terminal $T_{12}$ of the comparator CP and the feedback resistor $R_{F1}$ is interposed between the output terminal $T_{13}$ and the non-inverted input terminal $T_{12}$ of the comparator CP, the comparator CP can possess a hysteresis characteristic as included in its input-output characteristics by the application of a positive feedback on the comparator CP, thereby preventing chatterings due to noises and etc.

Fig. 10 is a wave form diagram illustrating an operation of the hysteresis comparator circuit of Fig. 9. In Fig. 10(a) there are shown the target signal $V_S$, the voltage $V_-$ (= $V_S$) applied to the inverted input terminal $T_{11}$ of the comparator CP, and the voltage $V_+$ applied to the non-inverted input terminal $T_{12}$ of the comparator CP. Further, in Fig. 10(b) there is shown the output voltage $V_O$ appearing at the output terminal $T_{13}$ of the comparator CP.

As described above, the hysteresis comparator circuit shown in Fig. 9 is caused to have a hysteresis characteristic by the application of a positive feedback through the input resistor $R_{I1}$ and the feedback resistor $R_{F1}$ so that there arises a voltage difference V with respect to the voltage $V_+$ between the risetime and falltime of the signal $V_S$ to be detected. That is, there appears a hysteresis width of the voltage V. Consequently, the pulse width $T_B$ of the output voltage $V_O$ appearing at the output terminal $T_{13}$ of the comparator CP becomes larger by T than the pulse width $T_A$ of the output voltage when the comparator CP has no hysteresis characteristic. That is, no accurate pulse width can be obtained. This also means that the judgment of termination of the pulse signal is delayed by that amount T.

In order to reduce the above-mentioned pulse width extension of T, the hysteresis width V may be made small but in that case, chatterings tend to take place due to noises.

To satisfy these contradictory requirements, the hysteresis component (voltage V) of the voltage $V_+$ may be eliminated midway between the risetime and falltime of the signal $V_S$ so that the voltage $V_+$ can be returned to the level of the reference signal $V_R$. Thus, as a prior art technique for eliminating such a hysteresis component of the voltage $V_+$, there is disclosed in the Japanese Unexamined Patent Application No. SHO 63-298029 a means for varying the reference voltage of a comparator by using an analog switch.

However, the above-mentioned circuit configuration for varying the comparator reference voltage has been disadvantageous in view of the substrate receiving space and manufacturing cost since a special circuit for varying the reference voltage must be added to a conventional hysteresis comparator circuit.

[Summary of the Invention]

Accordingly, an object of present invention is to provide a hysteresis comparator circuit which is capable of eliminating an undesired pulse width extension occurring due to a hysteresis and with which chatterings hardly take place.

Another object of the present invention is to provide a hysteresis comparator circuit which does not require an additional special circuit thereby saving the substrate accommodating space and manufacturing cost.

According to a first aspect of the present invention, there is provided a hysteresis comparator circuit comprising an input impedance element connected to a non-inverted input terminal of a comparator, and a feedback impedance element connected between an output terminal of the comparator and the non-inverted input terminal. The input impedance element and feedback impedance element are so set as to constitute a differentiation circuit when seen from the output terminal side of the comparator.

With the above arrangement, when a signal to be detected is inputted to an inverted input terminal of the comparator and a reference signal is inputted via the input impedance element to the non-inverted input terminal of the comparator, if the voltage at the inverted input terminal of the comparator exceeds the reference signal; i.e. the voltage at the non-inverted input terminal of the comparator, at the risetime of the voltage at the inverted input terminal of the comparator, the output voltage of the comparator turns from a HIGH-level to a LOW-level. Then, this LOW-level voltage is applied to the non-inverted input terminal of the comparator via the feedback impedance element.

In this instance, as the feedback impedance element and the input impedance element constitute a differentiation circuit whe seen from the output terminal side of the comparator, the voltage at the non-inverted input terminal of the comparator immediately drops below the voltage level of the reference signal to cause a hysteresis, and no chattering phenomenon due to noises takes place. Thereafter, the voltage of the non-inverted input terminal of the comparator continuously increases with a gradient determined by the characteristics of this differentiation circuit; i.e. the time constant determined by the feedback impedance element and the input impedance element, until it reaches the voltage level of the reference signal, so that the hysteresis is finally eliminated.

Furthermore, at its falltime, if the voltage of the target signal decreases down below the voltage of the reference signal the output voltage of the comparator turns from a LOW-level to a HIGH-level. Then, this HIGH-level voltage is supplied via the feedback impedance element to the non-inverted input terminal of the comparator.

In this case, the voltage at the non-inverted input terminal of the comparator immediately increases above the voltage level of the reference signal to cause a hysteresis and no chattering phenomenon due to noises takes place. After that, the voltage of the non-inverted input terminal of the comparator continuously decreases with a gradient determined by the characteristics of this differentiation circuit; i.e. the time constant determined by the feedback impedance element and the in put impedance element, until it reaches the voltage level of the reference signal, so that the hysteresis is finally eliminated.

As is explained in the foregoing description, in accordance with the hysteresis comparator circuit of the present invention, the voltage of the non-inverted input terminal of the comparator largely varies immediately after the output voltage of the comparator has changed from a HIGH-level to a LOW-level and also immediately after the output voltage of the comparator has subsequently changed from a LOW-level to a HIGH-level so that the comparator circuit may possess an appropriate hysteresis effective for suppressing the chattering phenomenon.

Furthermore, the voltage level before the output voltage of the comparator changes from a HIGH-level to a LOW-level can be equalized to the voltage level before the output voltage of the comparator subsequently changes from a LOW-level to a HIGH-level, so that it becomes possible to eliminate an undesirable extension of thepulse width resulting from the hysteresis.

Moreover, all that is required for arranging this circuit is only the connection of the feedback impedance element and the input impedance element so as to constitute the differentiation circuit when seen from the output terminal side of the comparator. Accordingly, it is not necessary to provide a particular circuit separately which results in saving the substrate accommodating space and manufacturing cost.

According to a second aspect of the present invention there is provided a hysteresis comparator circuit which comprises a feedback impedance element and an input impedance element where in at least either one of these two elements is constituted by a parallel circuit composed of first and second series circuits of which the first series circuit includes a first impedance element and a first unilateral conductive element that allows current to flow in one direction only, and the second serial circuit includes a second impedance element and a second unilateral conductive element that allows current to flow in the other direction only.

In this case, the impedance value of unilateral current path passing through the first series circuit including the first unilateral conductive element and the first impedance element is made different from the impedance value of the other current path passing through the second series circuit including the second unilateral conductive element and the second impedance element, in at least either of the feedback impedance element or the input impedance element.

With this arrangement, it becomes possible to intentionally vary the width of a hysteresis and the hysteresis attenuation characteristics of the circuit between the risetime and the fall time of the target signal.

Namely, the hysteresis width and hysteresis attenuation characteristics obtained when the output voltage of the comparator turns from a HIGH-level to a LOW-level at the risetime of the target signal can be made different from those obtained when the output voltage of the comparator subsequently turns from a LOW-level to a HIGH-level at the falltime of the target signal.

Accordingly, the hysteresis comparator circuit in accordance with the second aspect of the present invention, a wide variety of use can be expected. For example, where a plurality of target signals to be detected are continuously inputted, all the remaining signals that follow the first target signal can be intentionally ignored. That is, a masking is effectively carried out in this hysteresis comparator circuit embodying the present invention.

[Brief Description of the Drawings]

Fig. 1 is a circuit diagram showing a concrete configuration of a hysteresis comparator circuit according to a first embodiment of the present invention;

Fig. 2 is a circuit diagram showing a concrete example of the hysteresis comparator circuit shown in Fig. 1;

Fig. 3 is a waveform diagram showing an operation of the hysteresis comparator circuit shown in Fig. 2;

Fig. 4 is a circuit diagram showing another example of the hysteresis comparator circuit shown in Fig. 1;

Fig. 5 is a circuit diagram showing a hysteresis comparator circuit configuration according to a second embodiment of the present invention;

Fig. 6 is a wave form diagram showing an operation of the hysteresis comparator circuit shown in Fig. 5;

Fig. 7 is a waveform diagram also showing an operation of the hysteresis comparator circuit shown in Fig. 5;

Fig. 8 is a circuit diagram showing a hysteresis comparator circuit configuration according to a third embodiment of the present invention;

Fig. 9 is a circuit diagram showing an example of a conventional hysteresis comparator circuit configuration; and

Fig. 10 is a waveform diagram showing an operation of the hysteresis comparator circuit shown in Fig. 9.

Fig. 11 is a circuit diagram showing a hysteresis comparator circuit configuration according to a fourth embodiment of the present invention; and

Fig. 12 is a waveform diagram showing an operation of the hysteresis comparator circuit shown in Fig. 11.

[Detailed Description of Preferred Embodiments]

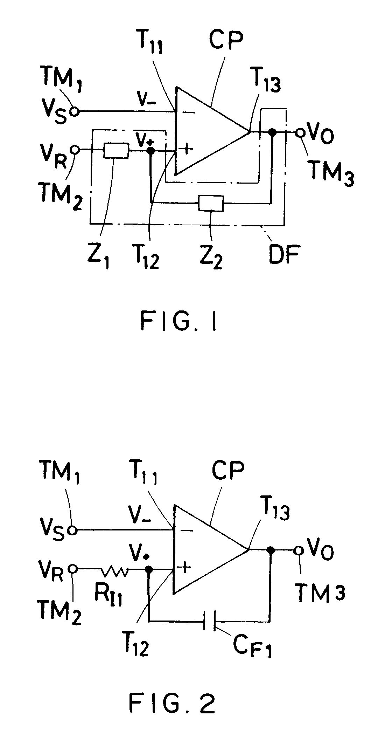

The first embodiment of the present invention will now be described by referring to Figs. 1 through 4. As shown in Fig. 1, an input impedance element $Z_1$ is connected to a non-inverted input terminal $T_{12}$ of a comparator CP and a feedback impedance element $Z_2$ is interposed between an output terminal $T_{13}$ and the non-inverted input terminal $T_{12}$ of the comparator CP, thereby forming a hysteresis comparator circuit.

The feedback impedance element $Z_2$ and the input impedance element $Z_1$ are connected with each other to cooperatively constitute a differential circuit DF when seen from the output terminal $T_{13}$ side of the comparator CP.

In this hysteresis comparator circuit, a signal $V_S$ to be detected is supplied from an input terminal $TM_1$ to an inverted input terminal $T_{11}$ of the comparator CP as a voltage $V_-$. This signal $V_S$ is represented by, for example, a particle detecting signal obtained from a particle measurement apparatus such as a flow cytometer or the like.

Further, a reference signal $V_R$ to be compared to the signal $V_S$ is supplied from an input terminal $TM_2$ via an input impedance element $Z_1$ to a non-inverted input terminal $T_{12}$ as a voltage $V_+$.

In addition, an output voltage $V_O$ at an output terminal $T_{13}$ of the comparator CP is fed back to the non-inverted input terminal $T_{12}$ through a feedback impedance element $Z_2$.

Then, the output voltage $V_O$ appearing at the output terminal $T_{13}$ of the comparator CP is taken out from an output terminal $TM_3$.

In the case of the above hysteresis comparator circuit, when the target signal $V_S$ is inputted to the inverted input terminal $T_{11}$ of the comparator CP and the reference signal $V_R$ is inputted to the non-inverted input terminal $T_{12}$ of the comparator CP through the input impedance element $Z_1$, and if the signal $V_S$; i.e. the voltage $V_-$ of the inverted input terminal $T_{11}$ of the comparator CP, exceeds the reference signal $V_R$; i.e. the voltage $V_+$ of the non-inverted input terminal $T_{12}$ of the comparator CP at its risetime, the output voltage $V_O$ of the comparator CP turns from a HIGH-level to a LOW-level. Then, this LOW-level voltage is supplied via the feedback impedance element $Z_2$ to the non-inverted input terminal $T_{12}$ of the comparator CP.

In this case, as the feedback impedance element $Z_2$ and the input impedance element $Z_1$ constitute a differentiation circuit DF when seen from the output terminal $T_{13}$ side of the comparator CP, the voltage $V_+$ of the non-inverted input terminal $T_{12}$ of the comparator CP immediately drops below the voltage level of the reference signal $V_R$ to generate a hysteresis so that no chattering takes place. After that, the voltage $V_+$ of the non-inverted input terminal $T_{12}$ of the comparator CP continuously increases with a gradient determined by the characteristics of this differentiation circuit DF; i.e. a time constant determined by the feedback impedance element $Z_2$ and the input impedance element $Z_1$, until it reaches the voltage level of the reference signal $V_R$. Therefore, the hysteresis is finally eliminated.

Furthermore, at the falltime of the target signal $V_S$, if the voltage of the detected signal $V_S$ decreases down below the voltage of the reference signal $V_R$, an output voltage $V_O$ of the comparator CP turns from a LOW-level to a HIGH-level. Then, this HIGH-level voltage is supplied via the feedback impedance element $Z_2$ to the non-inverted input terminal $T_{12}$ of the comparator CP.

In this case, the voltage $V_+$ of the non-inverted input terminal $T_{12}$ of the comparator CP immediately increases above the voltage level of the reference signal $V_R$ to cause a hysteresis. Thus, the chattering phenomenon due to noises is surely suppressed.

Thereafter, the voltage $V_+$ of the non-inverted input terminal $T_{12}$ of the comparator CP continuously decreases with a gradient determined by the characteristics of this differentiation circuit DF; i.e. the time constant determined by the feedback impedance element $Z_2$ and the input impedance element $Z_1$, until it reaches the voltage level of the reference signal $V_R$. Therefore, the hysteresis is finally eliminated.

As has been explained in the foregoing description, in accordance with this hysteresis comparator circuit of the present invention, the voltage $V_+$ of the non-inverted input terminal $T_{12}$ of the comparator CP is largely varied immediately after the output voltage $V_O$ of the comparator CP has changed from a HIGH-level to a LOW-level and also immediately after the output voltage $V_O$ of the comparator CP has subsequently changed from a LOW-level to a HIGH-level. Hence, it becomes possible for the comparator CP to possess an appropriate hysteresis characteristic effective for suppressing the chattering phenomenon.

Furthermore, the voltage level of the target signal $V_S$ before the output voltage $V_O$ of the comparator CP changes from a HIGH-level to a LOW-level is equalized with the voltage level of the target signal $V_S$ before the output voltage $V_O$ of the comparator CP subsequently changes from a LOW-level to a HIGH-level. Therefore, it becomes possible to eliminate an undesirable extension of the pulse width that is inevitably derived from the hysteresis.

Moreover, all that required for arranging this circuit is only to connect the feedback impedance element $Z_2$ and the input impedance element $Z_1$ with each other to cooperatively constitute the differential circuit DF when seen from the same side as the output terminal $T_{13}$ of the comparator CP. Accordingly, there is no requirement for additionally providing a special circuit, which results in the advantage of reducing the substrate accommodating space and the manufacturing cost.

Next, Fig. 2 shows a specific circuit example wherein a resistor is used as the input impedance element $Z_1$ and a capacitor is used as the feedback impedance element $Z_2$.

In Fig. 2, an input resistor $R_{I1}$ is one that is used as the input impedance element $Z_1$ and a feedback capacitor $C_{F1}$ is one that is used as the feedback impedance element $Z_2$. These input resistance $R_{I1}$ and the feedback capacitor $C_{F1}$ are connected with each other to cooperatively constitute a differentiation circuit when seen from the output terminal $T_{13}$ side of the comparator CP. Other components of this circuit are the same as those of the above-described circuit shown in Fig. 1.

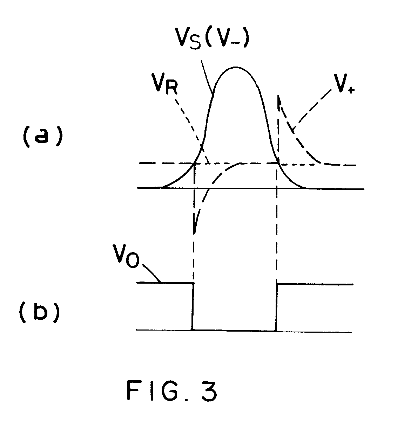

Fig. 3 is a waveform diagram showing an operation of the hysteresis comparator circuit shown in Fig. 2. Fig. 3(a) shows the target signal $V_S$ to be detected , the voltage $V_-$ ($= V_S$) applied to the inverted input terminal $T_{11}$ of the comparator CP, and the voltage $V_+$ applied to the non-inverted input terminal $T_{12}$ of the comparator CP. (In the initial condition, the voltage $V_+$ applied to the non-inverted input terminal $T_{12}$ of the comparator CP is equal to the reference signal $V_R$).

Further, in Fig. 3(b) there is shown the output voltage $V_O$ appearing at the output terminal $T_{13}$ of the comparator CP.

Though the operation of this circuit has been previously described with reference to Fig. 1, the same operation will be described again with reference to Fig. 3.

In the hysteresis comparator circuit shown in Fig. 2, when the target signal $V_S$ is smaller than the reference signal $V_R$, the output signal $V_O$ of the comparator CP is at HIGH-level. However, if the signal $V_S$ exceeds the reference signal $V_R$ at its risetime, the output signal $V_O$ of the comparator CP turns from a HIGH-level to a LOW-level.

Accordingly, the voltage $V_+$ of the non-inverted input terminal $T_{12}$ of the comparator CP immediately changes (drops) by the amount of variation of the output voltage $V_O$. In other words, the voltage $V_+$ of the non-inverted input terminal $T_{12}$ of the comparator CP changes by an amount corresponding to the difference between the output voltage $V_O$ at a HIGH-level and the output voltage $V_O$ at a LOW-level. However, the voltage $V_+$ once dropped continuously increases with a time constant of $C_{F1} \cdot R_{I1}$ until it returns to the voltage level of the reference signal $V_R$.

Furthermore, at the falltime of the target signal $V_S$, the output voltage $V_O$ of the comparator CP turns from a LOW-level to a HIGH-level when the signal $V_S$ becomes smaller than the reference signal $V_R$.

Accordingly, the voltage $V_+$ of the non-inverted input terminal $T_{12}$ of the comparator CP immediately changes (increases) by an amount corresponding to the amount of variation of the output voltage $V_O$. In other words, the voltage $V_+$ of the non-inverted input terminal $T_{12}$ of the comparator CP changes by an amount corresponding to the difference between the output voltage $V_O$ at a HIGH-level and the output voltage $V_O$ at a LOW-level. However, the voltage $V_+$ once increased continuously decreases with the time constant of $C_{F1} \cdot R_{I1}$ until it returns to the voltage level of the reference signal $V_R$.

Consequently, the comparator CP can compare the target signal $V_S$ with the same reference signal $V_R$ at both the risetime and falltime of the signal $V_S$. In other words, it becomes possible for the comparator CP to temporarily possess the hysteresis necessary for suppressing the chattering phenomenon only for a limited period of time, immediately after the output voltage $V_O$ of the comparator CP has turned from a HIGH-level to a LOW-level or vice versa.

Accordingly, an undesirable extension of the pulse width experienced in a conventional hysteresis comparator circuit no longer takes place. Thus it becomes possible to accurately detect a pulse width, and the chattering phenomenon can of course be effectively suppressed.

Furthermore, the circuit of the present invention uses a capacitor instead of a resistor as serving a conventional feedback impedance element so that it is not necessary to provide a particular circuit separately thereby saving the substrate accommodating space and manufacturing cost.

Moreover, it is possible to vary the time required for allowing the voltage $V_+$ at the non-inverted input terminal $T_{12}$ of the comparator CP to return to the voltage level of the reference voltage $V_R$ by varying the time constant.

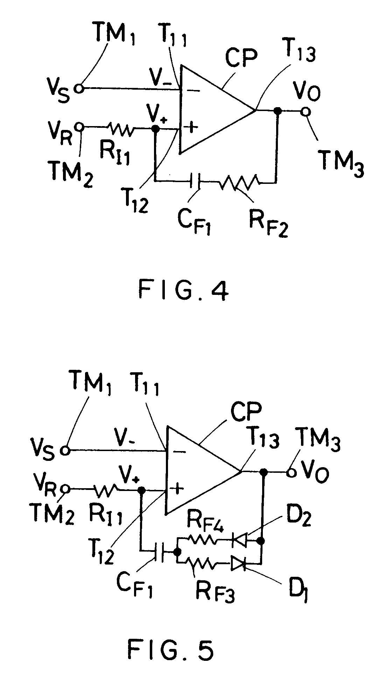

Next, Fig. 4 shows a concrete circuit example wherein a resistor is used as the input impedance element $Z_1$ and a series circuit of a capacitor and a resistor is used as the feedback impedance element $Z_2$.

In Fig. 4, the input resistor $R_{I1}$ is one that is used as the input impedance element $Z_1$ and a series circuit of a feedback capacitor $C_{F1}$ and a feedback resistor $R_{F2}$ is one that is used as the feedback impedance element $Z_2$. The feedback capacitor $C_{F1}$, feedback resistor $R_{F2}$, and input resistor $R_{I1}$ are connected with one another so as to constitute a differential circuit when seen from the output terminal $T_{13}$ side of the comparator CP. Other components of this circuit are the same as those shown in Fig. 2.

By using such a serial circuit of the feedback capacitor $C_{F1}$ and the feedback resistor $R_{F2}$ as the feedback impedance element $Z_2$, it becomes possible to vary the width of the hysteresis generating immediately after the output voltage $V_O$ of the comparator CP has changed from a HIGH-level to a LOW-level or vice versa. The width of this hysteresis can be properly determined depending on the kind of signal to be handled.

Moreover, the width of the hysteresis can also be changed in the same manner when the non-inverted input terminal $T_{12}$ of the comparator CP is grounded through a resistor. Other features are the same as those of the hysteresis comparator circuit shown in Fig. 2.

A second embodiment of the present invention will be explained in detail with reference to Figs. 5 through 7. As shown in Fig. 5, this hysteresis comparator circuit is composed of the input resistor $R_{I1}$ serving as the input impedance element $Z_1$ of Fig. 1, a feedback capacitor $C_{F1}$, feedback resistor $R_{F3}$, $R_{F4}$ and diodes $D_1$, $D_2$ serving as the feedback impedance element $Z_2$, with the remaining portion being the same as that in Fig. 1.

That is, the feedback impedance element is constituted such that a series circuit of the feedback resistor RF3 (an impedance element) and the diode $D_1$ (a first unilateral conductive element) is connected parallel to a series circuit of the feedback resistor $R_{F4}$ (a second impedance element) and the diode $D_2$ (a second unilateral current conductive element) and the feedback capacitor $C_{F1}$ is connected in series with the parallel circuit.

In this case, the values for the feedback resistors are set differently.

With this arrangement, when the output voltage $V_O$ of the comparator CP changes from a HIGH-level to a LOW-level at the risetime of the target signal $V_S$, the diode $D_1$ is turned on and the diode $D_2$ is turned off so that the width of hysteresis becomes $R_{I1}/(R_{I1} + R_{F3}) \cdot V_O$ and the time constant of hysteresis attenuation becomes $C_{F1}/(R_{I1} + R_{F3})$.

Furthermore, when the output voltage $V_O$ of the comparator CP turns from a LOW-level to a HIGH-level at the falltime of the target signal $V_S$, the diode $D_1$ is turned off and the other diode $D_2$ is turned on so that the width of hysteresis becomes $R_{I1}/(R_{I1} + R_{F4}) \cdot V_O$ and the time constant of hysteresis attenuation becomes $C_{F1}/(R_{I1} + R_{F4})$.

With this arrangement, it becomes possible to intentionally vary the hysteresis characteristics at the risetime and the falltime of the target signal $v_S$.

Namely, the hysteresis width and hysteresis attenuation characteristics at the time when the output voltage $V_O$ of the comparator CP turns from a HIGH-level to a LOW-level in the risetime of the target signal $V_S$ can be differentiated from those when the output voltage $v_O$ of the comparator CP subsequently turns from a LOW-level to a HIGH-level at the falltime of the target signal $V_S$.

For example, when more than two target signals $V_S$ to be detected are inputted in sequence, it is possible to ignore (mask) those following the first signal by intentionally increasing the time constant.

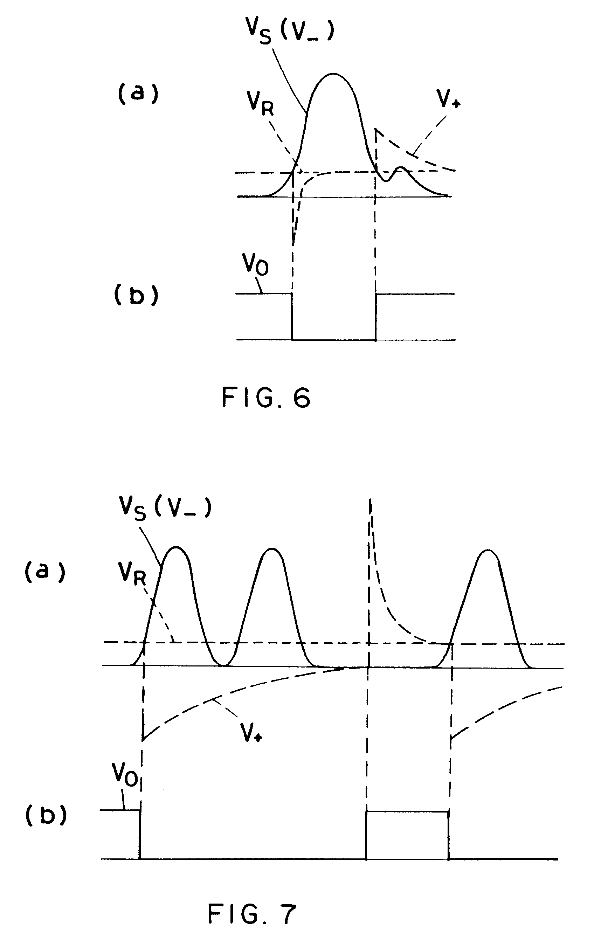

Figs. 6 and 7 are waveform diagrams showing an operation of the hysteresis comparator circuit of Fig. 5 wherein Figs. 6(a) and 7(a) correspond to Fig. 3(a), and 3(b) respectively.

Fig. 6 shows a waveform when the time elapsed from the generation of a hysteresis to the termination thereof at the risetime of a target signal $V_S$ is made sufficiently shorter than the pulse width of an analog pulse signal as the target signal $V_S$ and the time elapsed from the generation of a hysteresis to the termination thereof at the falltime of the signal $V_S$ is made longer than that at the risetime of the signal.

By setting such a characteristic, even if an analog pulse signal inputted as the target signal $V_S$ has irregulaties at the trailing-edge thereof, it becomes possible to accurately detect only the width of the first wave of the signal by ignoring its succeeding waves.

Fig. 7 shows a waveform when the time elapsed from the generation of a hysteresis to the termination thereof at the risetime of the target signal $V_S$ is sufficiently longer than the pulse width of analog pulse signal as the target signal $V_S$ and the time elapsed from the generation of a hysteresis to the termination thereof at the falltime of the signal is made shorter than that at the risetime thereof.

By setting such a characteristic, even if analog pulse signals are inputted in sequence as the signal $V_S$, it becomes possible to ignore all the pulse signals following the first one. Therefore, it becomes easy to perform a pulse number counting operation by excluding the ignored pulse signals.

The remaining portion is the same as that of the hysteresis comparator circuit of Fig. 2.

By the way, a similar operation can be performed even if the input resistor $R_{11}$ and the parallel circuit consisting of the feedback resistors $R_{F3}$, $R_{F4}$ and diodes $D_1$, $D_2$ are exchangd with each other in the circuit disclosed in Fig. 5.

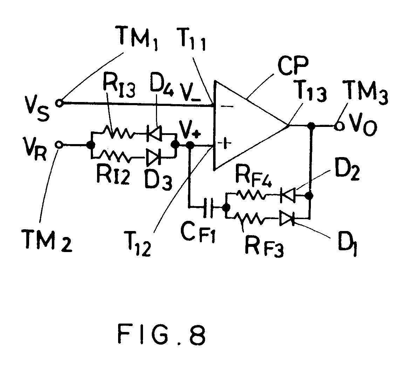

A third embodiment of the present invention will be explained with reference to Fig. 8.

As shown in Fig. 8, the hysteresis comparator circuit according to this embodiment uses a parallel circuit consisting of a first series circuit including an input resistor $R_{I2}$ and a diode $D_3$ and a second series circuit including an input resistor $R_{I3}$ and a diode $D_4$, instead of the input resistor $R_{I1}$ of Fig. 5. The remaining portion is the same as those of Fig. 5.

In this case, the resistance values of the input resistors $R_{I2}$, $R_{I3}$ and the feedback resistor $R_{F3}$, $R_{F4}$ are so set as to satisfy a relationship of $R_{I2} : R_{I3} = R_{I3} : R_{I4}$.

In the case of the circuit configuration of Fig. 5, the hysteresis width and time constant change together, but in the Fig. 8 embodiment, it becomes possible to vary only the time constant with the hysteresis width kept unchanged.

By the way, it is possible to set the ratio between the values of the input resistor $R_{I2}$, $R_{I3}$ and the values of the feedback resistors $R_{F3}$ and $R_{F4}$ so as to satisfy the equation of $R_{I2} + R_{F3} = R_{I3} + R_{F4}$. In that case, it is possible to vary only the hysteresis width while keeping the time constant unchanged.

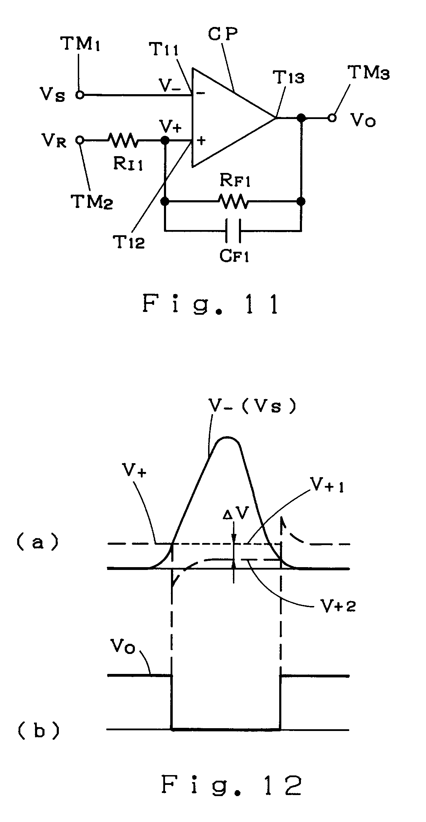

Now, a hysteresis comparator circuit as a fourth embodiment of the present invention will be explained by referring to Fig. 11 and 12. In the circuit shown in Fig. 11, the output voltage $V_0$ of the comparator CP is at a High-level when the signal $V_s$ to be detected (target signal) is smaller than the reference voltage level $V_{+1}$. However, as shown in Fig. 12, when the target signal $V_s$ exceeds the reference voltage level $V_{+1}$ at the rise time of the signal, the output voltage $V_0$ of the comparator CP changes from a High-level to a Low-level.

Accordingly, the voltage $V_+$ at the non-inverted input terminal $T_{12}$ of the comparator CP immediately changes (decreases) from the voltage level $V_{+1}$ by an amount equivalent to the amount of variation of the output voltage $V_0$. That is, the voltage $V_+$ at the non-inverted input terminal $T_{12}$ of the comparator CP changes by an amount corresponding to the difference between the High-level output voltage $V_0$ and Low-level output voltage $V_0$. However, the voltage $V_+$ thus decreased once increases with a time constant $C_{F1} \cdot (R_{11}/R_{F1})$ to finally reach the reference voltage level $V_{+2}$.

On the other hand, at the fall time of the target signal $V_s$, when the target signal $V_s$ is smaller than the reference voltage level $V_{+2}$, the output voltage $V_0$ of the comparator CP changes from a Low-level to a High-level.

Consequently, the voltage $V_+$ at the non-inverted input terminal $T_{12}$ also changes (increases) immediately from the voltage level $V_{+2}$ by the amount of variation of the output voltage. That is, the voltage $V_+$ changes by an amount corresponding to the difference between the high-level voltage $V_0$ and the low-level voltage $V_0$. However, the voltage $V_+$ thus increased once decreases with the time constant $C_{F1} \cdot (R_{11}/R_{F1})$ to finally reach the reference voltage level $V_{+1}$.

Accordingly, it is possible for the circuit to have a large hysteresis only for a period required to prevent chatterings immediately after the inversion of the output voltage $V_0$ of the comparator CP.

As a result, the generation of chatterings due to noises can be controlled.

In addition, since the circuit of this embodiment does not require the provision of any separate particular circuit except the mere addition of a capacitor to be connected to the resistor so as to serve as a conventional feedback impedance element, there is no increase in the substrate receiving space or in the cost of manufacturing the circuit.

Moreover, by changing the time constant, it is possible to vary the time required for the voltage $V_+$ at the non-inverted input terminal $T_{12}$ of the comparator CP to reach the reference voltage levels $V_{+1}$ and $V_{+2}$.

A hysteresis comparator circuit is provided wherein an input impedance element is connected to a non-inverted input terminal of a comparator, and a feedback impedance element is connected between an output terminal of the comparator and the non-inverted input terminal. The feedback impedance element and input impedance element are connected with each other to cooperatively constitute a differentiation circuit when seen from the output terminal side of the comparator. With this arrangement, it becomes possible to eliminate an undesirable extension of the pulse width resulting from a hysteresis and at the same time, to prevent chattering. Further, this hysteresis comparator circuit requires no additional special circuit there by reducing the substrate accommodating space and manufacturing cost.

## Claims

1. A hysteresis comparator circuit comprising a comparator, an input impedance element connected to a non-inverted input terminal of said comparator and a feedback impedance element connected between an output terminal of said comparator and said non-inverted input terminal, and wherein said feedback impedance element and said input impedance element are connected with each other to cooperatively constitute a differentiation circuit when seen from the output terminal side of said comparator.

2. A hysteresis comparator circuit in accordance with claim 1 in which said input impedance element is a resistor and said feedback impedance element is a capacitor.

3. A hysteresis comparator circuit in accordance with claim 1 in which said input impedance element is a resistor and said feedback impedance element is a series circuit of a capacitor and a resistor.

4. A hysteresis comparator circuit in accordance with claim 1 in which said input impedance element is a resistor and said feedback impedance element is a parallel circuit of a capacitor and a resistor.

5. A hysteresis comparator circuit in accordance with claim 1 in which at least either of said feedback impedance element or said input impedance element comprises a parallel circuit consisted of a first series circuit of a first unilateral conductive element allowing current to flow in one direction only and a first impedance element and a second series circuit of a second unilateral conductive element allowing current to flow only in a direction opposite the direction of the current flowing through said first unilateral conductive element and a second impedance element, and in which the impedance value of a unilateral current path passing through said first series circuit is made different from the impedance value of a unilateral current path passing through said second series circuit.

6. A hysteresis comparator circuit in accordance with claim 5 in which said feedback impedance element comprises a capacitor connected in said parallel circuit.

7. A hysteresis comparator circuit in accordance with claim 4 or 5 in which said first and second unilateral conductive elements are diodes, respectively, and said first and second impedance elements are resistors, respectively.

FIG. I

FIG. 2

FIG. 3

FIG. 4

FIG. 5

(a)

$V_S (V_-)$

$V_R$

$V_+$

(b)

$V_0$

FIG. 6

(a)

$V_S (V_-)$

$V_R$

$V_+$

$V_0$

(b)

FIG. 7

FIG.8

FIG. 9

FIG. 10

Fig. 11

Fig. 12

European Patent
Office

**EUROPEAN SEARCH REPORT**

Application Number

EP    93 10 2134

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 549 099 (YAMADA ET AL.) * column 3, line 6 - column 5, line 47; figures 3-9 * | 1-7 | H03K3/023 |
| | ----- | | |

|  |
|---|
| TECHNICAL FIELDS SEARCHED (Int. Cl.5) |
| H03K |

The present search report has been drawn up for all claims

| Place of search | Date of completion of the search | Examiner |
|---|---|---|
| THE HAGUE | 30 JUNE 1993 | CANTARELLI R.J.H. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
 
& : member of the same patent family, corresponding
   document

EPO FORM 1503 03.82 (P0401)